# EUROPÄISCHE PATENTSCHRIFT

(11) **EP 3 129 520 B1**
(45) Veröffentlichungstag und Bekanntmachung des Hinweises auf die Patenterteilung: **16.10.2019**
(21) Anmeldenummer: 15710500.8
(22) Anmeldetag: 18.03.2015
(51) Int. Cl.: B82Y 30/00, B82Y 40/00, C23C 14/50, C23C 16/458, H01L 21/673, C01B 32/16, H01L 21/67

(54) **AUF SEINEN BEIDEN VONEINANDER WEGWEISENDEN BREITSEITEN JE EIN SUBSTRAT TRAGENDER SUBSTRATTRÄGER**
SUBSTRATE CARRIER THAT CARRIES A SUBSTRATE ON EACH OF TWO BROAD SIDES OF THE SUBSTRATE CARRIER THAT FACE AWAY FROM EACH OTHER
PORTE-SUBSTRAT SUPPORTANT UN SUBSTRAT SUR SES DEUX CÔTÉS LARGES OPPOSÉS L'UN À L'AUTRE

(30) Priorität: 24.03.2014 DE 102014104009
(43) Veröffentlichungstag der Anmeldung: 15.02.2017
(73) Patentinhaber: Aixtron SE, 52134 Herzogenrath (DE)
(72) Erfinder: JOUVRAY, Alexandre, Hilton Huntingdon PE28 9QB (GB); RIPPINGTON, David Eric, Stetchworth Newmarket Suffolk CB8 9TZ (GB); TEO, Kenneth B. K., Cambridge Cambridgeshire CB23 5BH (GB); RUPESINGHE, Nalin L., Cambridge Cambridgeshire CB4 3NB (GB)
(74) Vertreter: Grundmann, Dirk
(86) Internationale Anmeldenummer: PCT/EP2015/055641
(87) Internationale Veröffentlichungsnummer: WO 2015/144514

(56) Entgegenhaltungen:
- WO-A1-2014/038803
- CN-U- 202 025 731
- DE-U1- 29 514 989
- KR-A- 20130 098 664
- US-A1- 2013 017 633
- US-A1- 2014 017 160

## Beschreibung

Die Erfindung betrifft einen Substratträger und einen mit dem Substratträger zusammenwirkenden CVD-Reaktor, in welchem der Substratträger angeordnet werden kann. Es handelt sich dabei um einen CVD- oder PVD-Reaktor, insbesondere zum Abscheiden von Kohlenstoff-Nano-Röhrchen. Der Substratträger bildet zwei voneinander wegweisende Breitseitenflächen aus.

Aus der DE 29514 989 U1 und aus den DE 41 25 334 A1, DE 92 10 359 U1 und DE 40 36 449 A1 sind Substratträger bekannt, die ein im Reaktorgehäuse geführtes Fußteil aufweisen, an welches sich zwei Flachkörper anschließen, die voneinander beabstandet sind und auf zwei sich gegenüberliegenden Breitseitenflächen Substrataufnahmezonen aufweisen. Zwischen den beiden Flachkörpern befindet sich ein Heizelement, um die beiden Flachkörper aufzuheizen. Vorrichtungen zum Beschichten von Substraten zeigen ferner die DE 195 22 574 A1, US 2010/0319766 A1 und US 2013/0084235 A1. Die Substrate liegen teilweise auf Substratträgern; teilweise befinden sich die Substrate aber auch frei zwischen zwei sich gegenüberliegenden Gaseinlassorganen. Die US 2013/0089666 A1 beschreibt ein zwei Breitseitenflächen aufweisendes Kupfersubstrat. Die Patentdokumente WO 2014/038803 A1 und KR 2013 0098664 A offenbaren Substratträger für CVD Reaktoren.

Die Erfindung betrifft eine Vorrichtung zum Abscheiden von Nano-Röhrchen aus Kohlenstoff. Hierzu werden gasförmige Ausgangsstoffe in eine Prozesskammer gebracht. Dies erfolgt mittels eines Gaseinlassorgans. Innerhalb der Prozesskammer befindet sich ein Substrat, das auf einem Substratträger angeordnet ist. Es wird ein kohlenstoffhaltiges Prozessgas, beispielsweise CH₄, C₂H₄, C₂H₂ oder C₆H₆ in die Prozesskammer eingebracht. Vorrichtungen zum Beschichten flexibler Substrate beschreiben u.a. die GB 2 458 776 A oder die JP 2005-133165 A.

Der Erfindung liegt die Aufgabe zugrunde, eine Vorrichtung oder Teile einer Vorrichtung zum Abscheiden von Kohlenstoff-Nano-Röhrchen, Graphene oder dergleichen zu verbessern.

Gelöst wird die Aufgabe durch die in den Ansprüchen angegebene Erfindung. Der erfindungsgemäße Substratträger besitzt zwei Breitseitenflächen. Die Breitseitenflächen weisen voneinander weg. Jede der beiden Breitseitenflächen bildet eine Substrat-Aufnahmezone aus. Der Substratträger ist ein flacher Körper, der auf jeder seiner beiden voneinander wegweisenden Breitseiten eine Substrat-Aufnahmezone aufweist. Diese kann einen rechteckigen Grundriss aufweisen. Der den Substratträger ausbildende Körper kann aus Quarz bestehen und eine maximale Dicke von 10 mm aufweisen. Seine minimale Kantenlänge beträgt vorzugsweise 100 mm. Die Substrat-Aufnahmezone kann von einem Rand des Körpers begrenzt sein. Es handelt sich bevorzugt um einen gerundeten Rand, um den ein mittlerer Abschnitt eines flexiblen Substrates, beispielsweise aus Al, Ni oder Cu herumlegbar ist, so dass zwei Endabschnitte des Substrates jeweils auf einer der beiden Substrat-Aufnahmezonen aufliegen kann. Es können aber auch zwei voneinander getrennte Substrate verwendet werden, wobei jeweils ein Substrat auf einer der beiden Breitseiten des Substratträgers mittels eines Fixierelementes befestigt ist. Das Fixierelement kann von mehreren Klemmen, Schrauben oder anderen geeigneten Elementen gebildet sein, mit denen das Substrat oder ein Abschnitt des Substrates fest an der Breitseitenfläche befestigt werden kann. Die Substrat-Aufnahmezone kann darüber hinaus quer zu den zuvor genannten Rändern verlaufende Ränder aufweisen. Bei diesen Rändern kann es sich um Übergangszonen handeln, in denen die Substrat-Aufnahmezone in einen Randabschnitt übergeht. Der Randabschnitt bildet einen Handhabungsabschnitt aus, an dem der Substratträger gegriffen oder geführt werden kann. Der Handhabungsabschnitt besitzt vorzugsweise Fenster. Die Fenster können einen rechteckigen Querschnitt aufweisen. Die Fenster können Gasdurchtrittsfenster sein. Sie können aber auch zur manuellen Handhabung verwendet werden. Sie bilden dann Grifffenster aus. Die Fenster können voneinander verschiedene Größen aufweisen. Der Handhabungsabschnitt kann darüber hinaus auch Vorsprünge ausbilden. Diese Vorsprünge können über die Randkante der Substrat-Aufnahmezone hinausragen und dienen u.a. der Befestigung des Substratträgers innerhalb eines CVD- oder PVD-Reaktors. Die Vorsprünge erstrecken sich in Flächenerstreckungsrichtung und bilden Randabschnitte aus, gegenüber denen eine Randkante der Aufnahmezone zurückspringend verläuft. Der Abstand zweier gegenüberliegender Randkanten der Aufnahmezone ist somit kleiner, als der Abstand zweier gegenüberliegender Ränder zweier voneinander weg weisender Vorsprünge der beiden Handhabungsabschnitte. Der Reaktor beziehungsweise die Prozesskammer weist Führungselemente auf, die insbesondere Nuten besitzen, in welche Nuten die Vorsprünge der Handhabungsabschnitte hineingreifen. Die Vorsprünge der Handhabungsabschnitte bilden somit Führungsabschnitte aus. Die Nuten haben dabei eine Nuttiefe, die geringer ist als der Überstand der Vorsprünge gegenüber der Randkante der Aufnahmezone. Dies hat zur Folge, dass die Randkante der Aufnahmezone entfernt von den Führungselementen liegt. Bevorzugt ist in jeder der vier Ecken des Substratträgers ein Führungsabschnitt vorgesehen, der jeweils über den Rand der Substrat-Aufnahmezone hinausragt. Der CVD-Reaktor kann eine Beladeöffnung aufweisen, die sich in einer Vertikalrichtung erstreckt. In vertikaler Orientierung, also mit einer Randkante nach oben weisend und mit einer anderen Randkante nach unten weisend, kann der Substratträger durch die Beladeöffnung in die Prozesskammer des Reaktorgehäuses hineingeschoben werden. Die Prozesskammer besitzt in Vertikalrichtung sich erstreckende und gegenüberliegende Gaseinlassorgane, jeweils in Form eines Showerheads, also mit einer Gasaustrittsfläche, die eine Vielzahl gleichmäßig verteilter Gasaustrittsöffnungen aufweist. Durch die beiden aufeinander zu weisenden Gasaustrittsflächen kann das oben genannte Prozessgas in die Prozesskammer hineinfließen. Durch eine chemische Zerlegungsreaktion bilden sich auf den beiden voneinander wegweisenden Breitseitenflächen des Substratträgers, also auf den dort aufliegenden Substraten, Nano-Röhrchen. Es handelt sich bevorzugt um eine katalytische Reaktion, die bei etwa 1.000°C auf der Oberfläche des Substrates stattfindet. Dabei bilden sich quer zur Erstreckungsebene des Substrates wachsende Nanoröhrchen oder Graphene aus Kohlenstoff.

Ein Ausführungsbeispiel der Erfindung wird nachfolgend anhand beigefügter Zeichnungen erläutert. Es zeigen:
- Fig. 1: eine Explosionsdarstellung eines Substratträgers,
- Fig. 2: die Breitseitenansicht eines Substratträgers,
- Fig. 3: die Schmalseitenansicht eines Substratträgers,
- Fig. 4: den Schnitt gemäß der Linie IV-IV in Figur 2, wobei auf jeder der beiden Breitseitenflächen des Substratträgers je ein Substrat 6 angeordnet ist,
- Fig. 5: eine Darstellung gemäß Figur 4, wobei der Substratträger 1 ein flexibles Substrat 6 trägt, das sich über die Randkante 11 erstreckt,

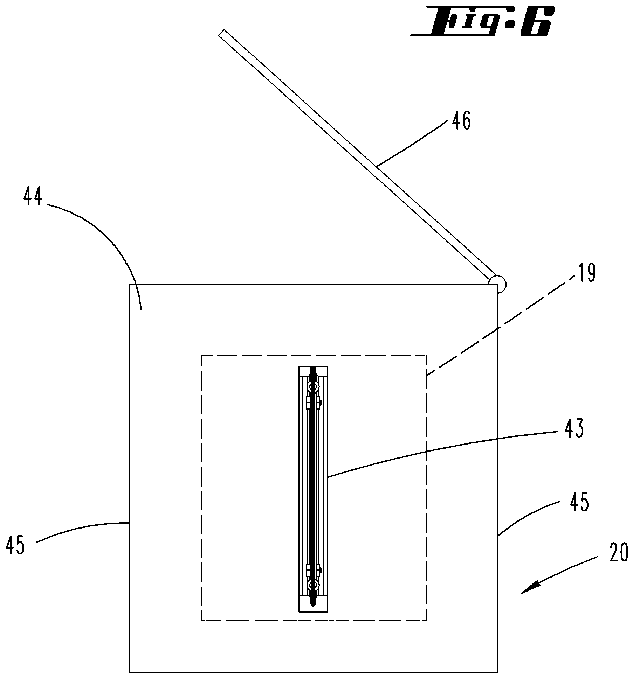

- Fig. 6: eine Seitenansicht auf ein Reaktorgehäuse 20 mit geöffnetem Deckel 46 und angedeutetem, darin angeordnetem Prozesskammergehäuse 19,

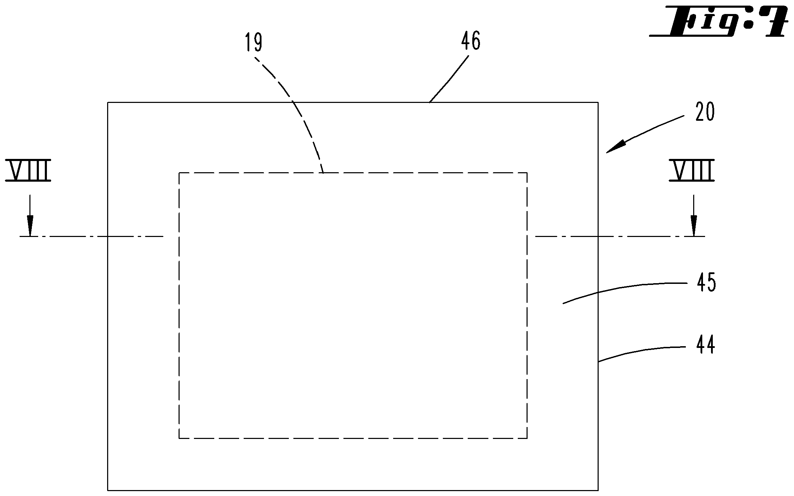

- Fig. 7: das Reaktorgehäuse 20 in der Frontansicht mit geschlossenem Deckel und angedeutetem, darin angeordnetem Prozesskammergehäuse 19,

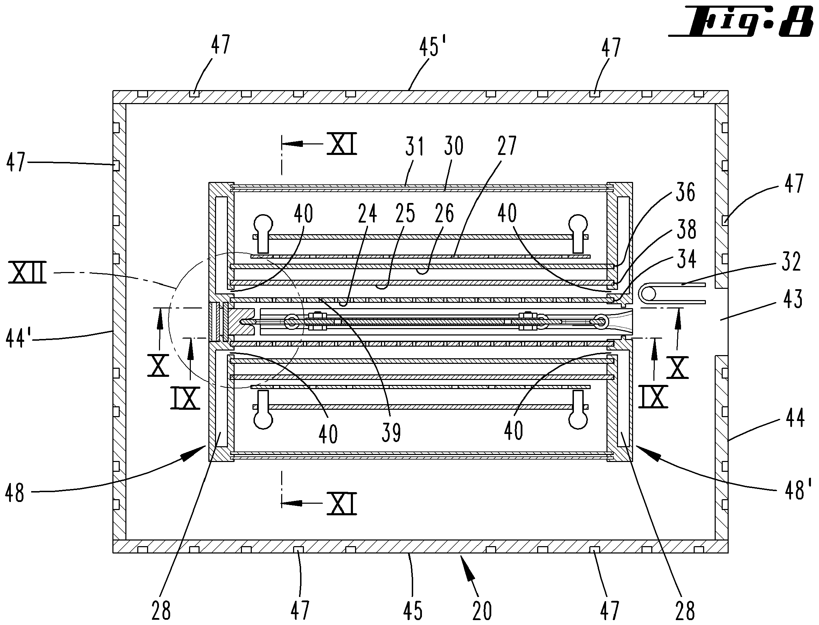

- Fig. 8: einen Schnitt gemäß der Linie VIII-VIII in Figur 7,
- Fig. 9: einen Schnitt gemäß der Linie IX-IX in Figur 8 mit Blick auf den im Prozesskammergehäuse 19 angeordnetem Substratträger 10,

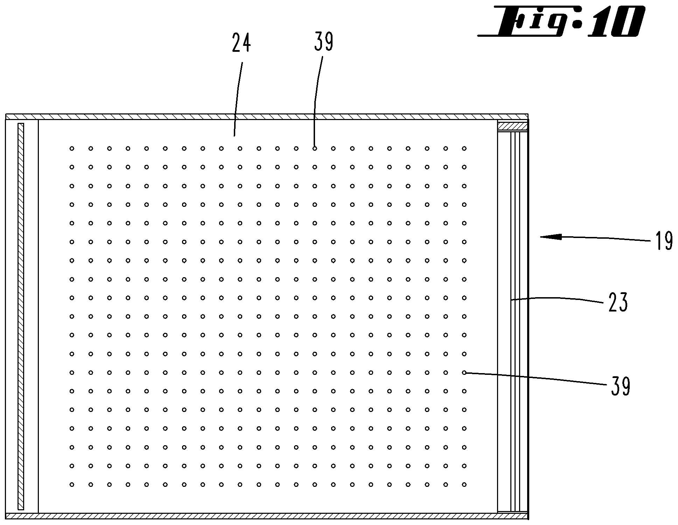

- Fig. 10: einen Schnitt gemäß der Linie X-X in Figur 8 mit Blick auf die Gasauslassplatte 24,

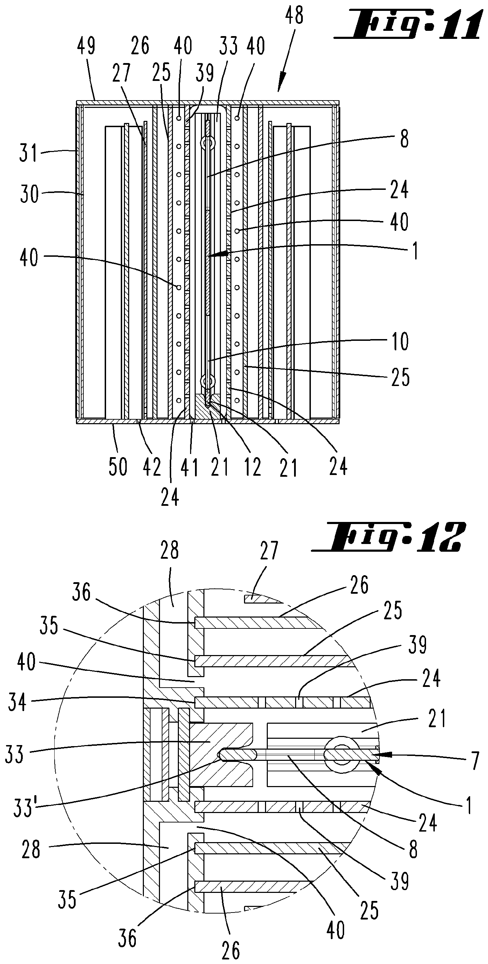

- Fig. 11: einen Schnitt gemäß der Linie XI-XI in Figur 8 mit Blick auf die prozesskammergehäuseinnenseitige Seite einer Wandung 48 des Prozesskammergehäuses 19,
- Fig. 12: vergrößert den Ausschnitt XII in Figur 8.

Das in den Zeichnungen dargestellte Reaktorgehäuse 20 besitzt eine quaderförmige Gestalt mit vier Seitenwänden 44, 44'; 45, 45'. Die obere Gehäusewand bildet einen aufschwenkbaren Deckel 46. Im Betrieb des Reaktors ist der Deckel 46 geschlossen. Er kann allerdings zu Wartungszwecken geöffnet werden.

Die Seitenwände 44, 44'; 45, 45' besitzen Kanäle 47, durch die eine Kühlflüssigkeit hindurchströmen kann, um die Wände 44, 44'; 45, 45' zu spülen.

Eine der Seitenwände 44 besitzt eine sich in Vertikalrichtung erstreckende Öffnung 43. Die Öffnung 43 kann mit einem nicht dargestellten Schieber gasdicht verschlossen werden. Es handelt sich um eine Be- und Entladeöffnung.

Innerhalb des Reaktorgehäuses 20 befindet sich ein Prozesskammergehäuse 19, welches ebenfalls eine sich in Vertikalrichtung erstreckende Be- und Entladeöffnung 23 aufweist. Das Prozesskammergehäuse 19 besitzt in seinem Inneren ein unteres Führungselement 21 und ein oberes Führungselement 22. Beide Führungselemente 21, 22 haben eine Leistenform und besitzen aufeinander zu weisende Nuten 21', 22'. Zwei Gaseinlassorgane 24, 25 begrenzen Vertikalseiten einer Prozesskammer. Ein Substratträger 1 kann durch die vertikalen Beladeöffnungen 23, 43 in die Prozesskammer eingeschoben werden. Hierbei greifen Führungsabschnitte 12 des Substratträgers 1 in Nuten 21', 22' der Führungselemente 21, 22 ein. Im eingesetzten Zustand befindet sich der Substratträger 1 mittig zwischen den beiden Gaseinlassorganen 24. Alle sechs Wände des quaderförmigen Reaktorgehäuses 20 können Temperierkanäle 47 aufweisen, durch die eine Temperierflüssigkeit strömen kann, um die Reaktorwände entweder zu kühlen oder aufzuheizen.

Der Substratträger 1 ist ein Flachkörper und besitzt einen im Wesentlichen rechteckigen Grundriss. Er besitzt zwei voneinander wegweisende Breitseitenflächen 2, 3, die jeweils eine Substrat-Aufnahmezone 4, 5 ausbilden. Die voneinander wegweisenden Substrat-Aufnahmezonen 4, 5 haben einen im Wesentlichen rechteckigen Querschnitt.

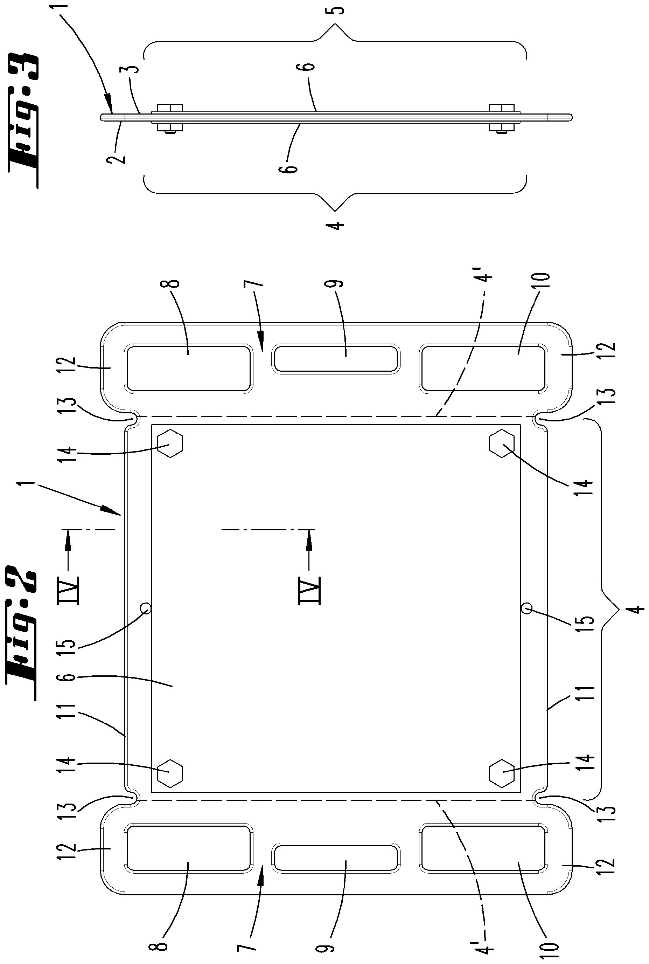

Die Figur 2 zeigt eine Breitseitenflächen 2 mit der Substrat-Aufnahmezone 4. Die gegenüberliegende Breitseitenflächen 3 ist mit ihrer Substrat-Aufnahmezone 5 identisch ausgebildet.

Der Flachkörper, aus dem der Substratträger 1 besteht, hat eine Materialstärke, die geringer ist als 10 mm. Die Randkantenlänge des Substratträgers 1 beträgt mindestens 100 mm.

Die Substrat-Aufnahmezone 4, die zur Substrat-Aufnahmezone 5 gleichgestaltet ist, besitzt zwei erste Ränder 4'. Bei den ersten Rändern 4' handelt es sich um gedachte Linien. Die Substrat-Aufnahmezone 4 besitzt darüber hinaus zweite Ränder, die von Randkanten 11 des Substratträgers 1 ausgebildet sind. Die Randkanten 11 sind verrundet.

In Eckbereichen der Substrat-Aufnahmezonen 4, 5 befinden sich Fixierelemente 14. Die Fixierelemente 14 sind im Ausführungsbeispiel als Schrauben 14 mit Muttern 14' dargestellt. Die Fixierelemente 14, 14' können aber auch Klemmelemente sein. Mit diesen Fixierelementen 14, 14' wird ein im Wesentliches rechteckiges Substrat 6 auf einer der beiden Substrat-Aufnahmezonen 4, 5 befestigt. Jeweils ein Substrat 6 befindet sich auf einer der beiden Breitseitenflächen 2, 3, so dass die beiden voneinander wegweisenden Substrat-Aufnahmezonen 4, 5 jeweils ein im Wesentlichen rechteckiges Substrat 6 tragen, wobei die Substrate 6 mit den Fixierelementen 14, 14' am Substratträger 1 befestigt sind. Bei den Substraten kann es sich um Kupfer-, Aluminium- oder um Nickelsubstrate handeln, die mit aus Kohlenstoff bestehenden Nanoröhrchen beschichtet werden, die quer zur Erstreckungsebene auf der Substratoberfläche aufwachsen.

Die Randkanten 11 gehen unter Ausbildung einer Einbuchtung 13 in Vorsprünge 12 über. Es handelt sich dabei um die oben erwähnten Führungsvorsprünge. Diese werden von den beiden Endabschnitten von Randabschnitten 7 des Substratträgers 1 ausgebildet. Die Randabschnitte 7 grenzen unmittelbar an die Ränder 4' an. An jeweils einem der beiden voneinander wegweisenden Ränder 4' grenzt ein Randabschnitt 7 an, der jeweils einen Handhabungsabschnitt ausbildet. Die Vorsprünge 12 erstrecken sich in der Erstreckungsebene des Substratträgers 1 und bilden Randabschnitte aus, die von der Randkante 11 beabstandet sind.

Die beiden gleich gestalteten Handhabungsabschnitte 7 besitzen nicht nur die die jeweilige Randkante 11 der Substrat-Aufnahmezone 4, 5 überragenden Vorsprünge 12, sondern auch fensterartige Öffnungen 8, 9, 10. Es handelt sich dabei um drei Rechtecköffnungen, durch die Gas hindurchströmen kann, die aber auch zur manuellen Handhabung verwendet werden können. Hierzu werden die Öffnungen 8, 9, 10 als Grifföffnungen verwendet. Die mittlere rechteckige Öffnung kann von einem Greifer eines Handhabungsarmes gegriffen werden.

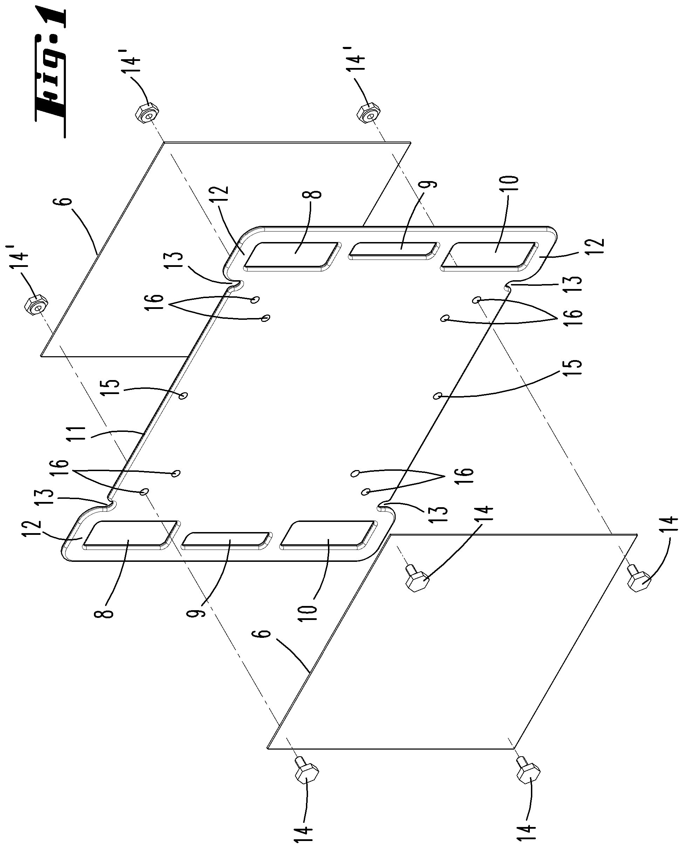

Wie die Figur 1 zeigt, besitzt der Substratträger 1 diverse Bohrungen 15, 16. Die Bohrungen 16 dienen der Fixierung der Fixierelemente 14 am Substratträger 1. Die Bohrung 15 kann ebenfalls als Befestigungsbohrung für ein Fixierelement verwendet werden. Die Bohrung 15 kann aber auch ein Anschlagelement aufweisen.

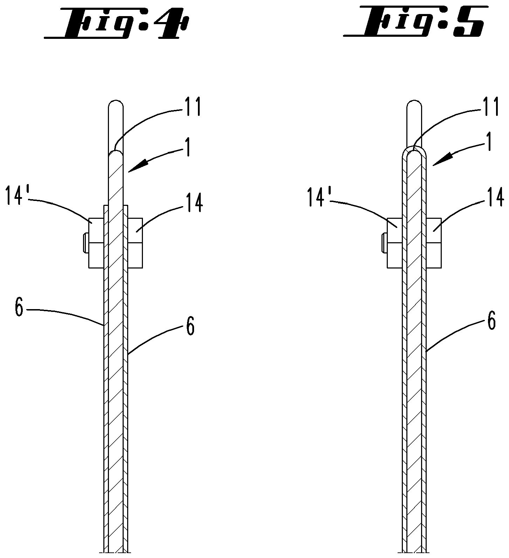

Die Figur 4 zeigt eine erste Verwendungsart des Substratträgers 1, bei der der Substratträger 1 auf seinen voneinander wegweisenden Breitseitenflächen 2, 3 jeweils ein Substrat 6 trägt.

Die Figur 5 zeigt eine zweite Verwendungsart des Substratträgers 1. Hierbei ist das vom Substratträger 1 getragene Substrat 6 flexibel. Es besitzt zwei Endabschnitte, die jeweils einer der beiden Substrat-Aufnahmezonen 4, 5 zugeordnet sind und dort befestigt sind. Ein mittlerer Abschnitt des Substrates 6 liegt an der gerundeten Randkante 11 an. Das Substrat 6 ist somit U-förmig um die Randkante 11 gefaltet.

Bei dem Substrat kann es sich um eine dünne Kupfer-, Nickel- oder Aluminiumfolie handeln. Mit den Gaseinlassorganen 24 wird ein Prozessgas (H₂, NH₃, AR, N₂, CH₄, C₂H₄, C₂H₂ oder C₆H₆) in die Prozesskammer eingeleitet. Durch eine chemische, insbesondere katalytische Reaktion zerlegen sich die Kohlenwasserstoffe in Kohlenstoff. Es kann sich dabei um eine pyrolytische Oberflächenreaktion handeln. Auf dem Substrat scheidet sich Graphene ab oder es scheiden sich dort Nano-Tubes ab.

Der Innenraum des Reaktorgehäuses 20 kann evakuiert werden. Hierzu dient eine nicht dargestellte Vakuumpumpe.

Das Prozesskammergehäuse 19 besitzt sechs Wände, die zu zugeordneten Wänden 44, 44'; 45, 45' beziehungsweise 48, 31, 49, 50 des Reaktorgehäuses 20 parallel verlaufen. Die Wände des Prozesskammergehäuses 19 sind von den Wänden des Reaktorgehäuses 20 beabstandet.

Eine Wand 48 des Prozesskammergehäuses 19 bildet Hohlräume 28 aus. Diese Hohlräume 28 sind Bestandteil einer Gaseinspeiseeinrichtung. Der Hohlraum 28 kann von außen her mit einem Prozessgas gespeist werden, das, wie weiter unten noch erläutert wird, über Öffnungen 40 in das Innere des Prozesskammergehäuses 19 eintreten kann. Es sind zwei sich gegenüberliegende Gehäusewände 48, 48' vorgesehen, die mehrteilig ausgebildet sind. Die Gehäusewandung 48' bildet die oben erwähnte Beladeöffnung 23 aus. Beide Gehäusewände 48, 48' besitzen auf ihrer zum Inneren des Prozesskammergehäuses 19 gewandten Seite eine Vielzahl von parallel zueinander und in Vertikalrichtung verlaufenden Halteaussparungen 34 bis 38. Die Halteaussparungen 34 bis 38 werden jeweils von Vertikalnuten gebildet. In den Halteaussparungen 34 bis 38 befinden sich die Ränder von plattenförmigen Elementen 24, 25, 26, 30, 31 des Prozesskammergehäuses 19. Bezogen auf eine Mittelebene hat das Prozesskammergehäuse 19 eine klappsymmetrische Gestalt. In dieser Mittelebene befindet sich der Substratträger 1 beziehungsweise befinden sich die Halteelemente 21, 22 und 33, die jeweils Nuten 21', 22' und 33' aufweisen zur Halterung des Substratträgers 1.

Auf jeder der beiden Breitseiten des Substratträgers 1 befindet sich ein Gaseinlassorgan jeweils in Form eines Showerheads. Der jeweilige Showerhead wird von einer aus Quarz gefertigten Gaseinlassplatte 24 ausgebildet, die mit zwei voneinander weg weisenden Rändern jeweils in eine Halteaussparung 34 eingeschoben ist. Die Gaseinlassplatte 24 besitzt eine Vielzahl von gleichmäßig über die Fläche der Gaseinlassplatte 24 verteilt angeordnete Gasaustrittsöffnungen 39, zum Austritt eines von einem Trägergas transportierten Prozessgases in die zwischen den beiden sich gegenüberliegenden Gaseinlassplatten 24 angeordnete Prozesskammer.

Bezogen auf die Lage der Prozesskammer rückwärtig der Gaseinlassplatte 24 befindet sich ein Volumen, welches von den oben genannten Gaseinspeiseöffnungen 40 mit Prozessgas beziehungsweise Trägergas versorgt wird, was durch die Gasaustrittsöffnungen 39 in die Prozesskammer eintreten kann.

Parallel zur Gaseinlassplatte 24 erstreckt sich eine Rückwand 25 des Gaseinlassorgans. Die Seitenränder der Rückwand 25 sind in die Halteaussparungen 35 eingeschoben.

Rückwärtig der Rückwand 25 befindet sich eine weitere Quarzplatte 26, deren Ränder in Halteaussparungen 36 eingeschoben sind.

Rückwärtig der Quarzplatte 26 befindet sich eine Widerstandsheizung 27. Es handelt sich dabei um eine mäanderförmig verlaufende Metallplatte, durch die ein Strom fließen kann, so dass sich das Heizelement 27 aufheizen kann. Die aus Quarz bestehenden Gaseinlassplatte 24, Rückwand 25 und Platte 26 sind im Wesentlichen transparent für die vom Heizelement 27 erzeugte infrarote Strahlung, die das Substrat 6 auf etwa 1.000°C Substrattemperatur aufheizen kann. Es sind Anschlusskontakte vorgesehen, um die beiden Heizelemente 27 zu bestromen.

Rückwärtig des Heizelements 27 befindet sich eine Schirmplatte 29, die auch als Reflektor wirken kann. Diese Schirmplatte 29 ist an der Halterung des Heizelements 27 befestigt, die auch zur Stromversorgung dient.

In den parallel zu den Vertikalrändern der Wände 48, 48' verlaufenden Halteaussparungen 37, 38 sind die Ränder eines Reflektors 30 und einer Rückwand 31 eingeschoben.

Das Prozesskammergehäuse 19 besitzt eine Decke 49, die entfernbar ist. Wird die Decke 49 bei geöffnetem Deckel 46 entfernt, so können die Platten 24, 25, 26, 37, 38 nach oben aus dem Prozesskammergehäuse 19 herausgezogen werden. Sie können dann gereinigt oder ausgetauscht werden. Ebenso einfach lassen sich die Platten 24, 25, 26, 30, 31 wieder in die ihnen zugeordneten Halteaussparungen 34 bis 38 einschieben.

Die Bodenplatte 50 besitzt Gasaustrittsöffnungen 41, aus denen das durch die Öffnung 39 in die Prozesskammer eingeströmte Gas aus der Prozesskammer austreten kann. Es sind ferner Gasaustrittsöffnungen 42 vorgesehen, die zum Austritt eines Spülgases dienen, welches in den Raum jenseits der beiden Showerheads, in denen sich das Heizelement 27 befindet, eingespeist wird.

Die oben erwähnten Führungselemente 21, 22, 33 besitzen jeweils eine nutförmige Ausnehmung 21', 22', 33', welche mit einem abgerundeten Mündungsbereich Findungsflanken für die Randkante des Substratträgers 1 ausbilden.

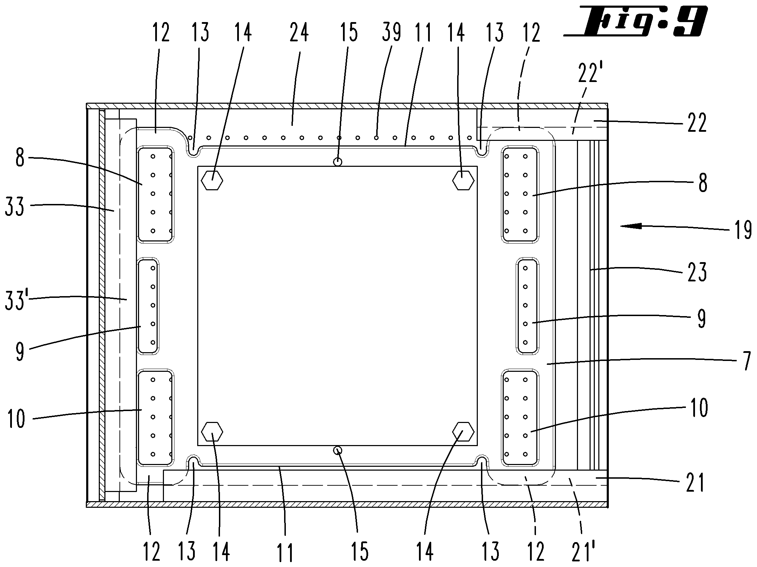

Aus der Figur 9 ist ersichtlich, dass die Randkanten 11 in eingeschobenem Zustand frei sind. Sie besitzen einen Abstand zu den Führungselementen 21 beziehungsweise 22.

Vor der Beladeöffnung 23 des Prozesskammergehäuses 19 befindet sich ein um eine Vertikalachse drehbarer Reflektor 32. Im Betrieb der Prozesskammer nimmt der drehbare Reflektor 32 eine Position ein, dass seine Reflektionsfläche vor der Beladeöffnung 23 steht. Soll die Prozesskammer be- beziehungsweise entladen werden, so wird der drehbare Reflektor 32 verschwenkt, so dass die beiden miteinander fluchtenden Öffnungen 23, 43 frei zum Durchtritt des Substratträgers 1 sind.

Die vorstehenden Ausführungen dienen der Erläuterung der von der Anmeldung insgesamt erfassten Erfindungen, die den Stand der Technik zumindest durch die folgenden Merkmalskombinationen jeweils eigenständig weiterbilden, nämlich:
Eine Vorrichtung, die dadurch gekennzeichnet ist, dass die erste Breitseitenfläche 2 und die zweite Breitseitenfläche 3 jeweils eine Substrat-Aufnahmezone 4, 5 aufweisen, in denen Fixierelemente 14, 14', 15 vorgesehen sind, mit denen jeweils ein Substrat 6 oder Abschnitte eines Substrates 6 an der Breitseitenfläche 2, 3 befestigbar ist.

Eine Vorrichtung, die dadurch gekennzeichnet ist, dass der Substratträger 1 ein flacher, insbesondere aus Quarz bestehender Körper ist und die Substrat-Aufnahmezonen 4, 5 einen im Wesentlichen rechteckigen Grundriss aufweisen, wobei der Körper insbesondere eine Dicke von maximal 10 mm und eine Kantenlänge von mindestens 100 mm besitzt.

Eine Vorrichtung, die dadurch gekennzeichnet ist, dass die Substrat-Aufnahmezone 4, 5 zwei voneinander wegweisende Ränder 4' aufweist, an die sich jeweils insbesondere materialeinheitlich ein Handhabungsabschnitt 7 anschließt.

Eine Vorrichtung, die dadurch gekennzeichnet ist, dass der Handhabungsabschnitt 7 fensterartige, insbesondere rechteckige Öffnungen 8, 9, 10 aufweist.

Eine Vorrichtung, die dadurch gekennzeichnet ist, dass der Handhabungsabschnitt 7 Vorsprünge 12 aufweist, die über quer zu den ersten Rändern 4' sich erstreckende zweite Ränder 11 der Substrat-Aufnahmezone 4 ragen.

Eine Vorrichtung, die dadurch gekennzeichnet ist, dass zumindest ein zweiter Rand 11 der Substrat-Aufnahmezone 4, 5 eine insbesondere gerundete Randkante des Substratträgers 1 ist, um die ein flexibles Substrat 6 derart herumlegbar ist, dass das Substrat 6 mit zwei Abschnitten an jeweils einer Substrat-Aufnahmezone 4, 5 befestigbar ist.

Eine Vorrichtung, die dadurch gekennzeichnet ist, dass der zweite Rand 11 gegenüber einer im Wesentlichen parallel zum zweiten Rand 11 verlaufenden Randkante des Vorsprungs 12 zurückspringend verläuft.

Eine Vorrichtung, die dadurch gekennzeichnet ist, dass das Reaktorgehäuse 20 Führungselemente 21, 22, 33 aufweist, entlang derer der Substratträger 1 mit seinen Vorsprüngen 12 verschiebbar ist, wobei insbesondere vorgesehen ist, dass nur die Vorsprünge 12 in von den Führungselementen 21, 22 gebildeten Nuten 21', 22', 33' eingreifen.

Eine Vorrichtung, die dadurch gekennzeichnet ist, dass der Substratträger 1 in einer vertikalen Ausrichtung durch eine sich in Vertikalrichtung erstreckende Beladeöffnung 23 in den Zwischenraum zwischen zwei Gaseinlassorganen 24 des Reaktorgehäuses 20 einschiebbar ist.

**Bezugszeichenliste:**

| | | | |
|---|---|---|---|
| 1 | Substratträger | 22 | Führungselement 22' Nut |
| 2 | Breitseitenfläche | 23 | Be- /Entladeöffnung |
| 3 | Breitseitenfläche | 24 | Gaseinlassorgan, -platte |
| 4 | Substrat-Aufnahmezone | 25 | Rückwand |
| 4' | Rand | 26 | Quarzplatte |
| 5 | Substrat-Aufnahmezone | 27 | Heizelement |
| 5' | Rand | 28 | Gaseinspeiseeinrichtung; Hohlraum |
| 6 | Substrat | 29 | Schirmplatte |
| 7 | Handhabungs-/Randabschnitt | 30 | Reflektor |
| 8 | Öffnung | 31 | Rückwand |
| 9 | Öffnung | 32 | drehbarer Reflektor |
| 10 | Öffnung | 33 | Halteelement |
| 11 | Randkante | 33' | Nut, Ausnehmung |
| 12 | Vorsprung/Führungsabschnitt | 34 | Halteaussparung |
| 13 | Einbuchtung | 35 | Halteaussparung |
| 14 | Fixierelement/Schraube | 36 | Halteaussparung |
| 14' | Fixierelement/Mutter | 37 | Halteaussparung |
| 15 | Bohrung | 38 | Halteaussparung |
| 16 | Bohrung | 39 | Gasaustrittsöffnung |
| | | 40 | Gaseinspeiseöffnung |
| | | 41 | Gasaustrittsöffnung |
| 19 | Prozesskammergehäuse | 42 | Gasaustrittsöffnung |
| 20 | Reaktorgehäuse | 43 | Beladeöffnung |
| 21 | Führungselement | 44 | Wand |
| 21' | Nut, Ausnehmung | 44' | Wand |
| 45 | Wand | | |
| 45' | Wand | | |
| 46 | Wand, Deckel | | |
| 47 | Temperierkanal | | |
| 48 | Gehäusewand | | |
| 48' | Gehäusewand | | |
| 49 | Deckenplatte | | |
| 50 | Bodenplatte | | |

## Patentansprüche

1. Substratträger zur Anordnung in einem CVD- oder PVD-Reaktor (20), insbesondere zum Abscheiden von Kohlenstoff-Nano-Röhrchen und Graphene, mit einer ersten Breitseitenfläche (2) zur Aufnahme eines zu beschichtenden Substrates (6) und einer von der ersten Breitseitenfläche (2) wegweisenden zweiten Breitseitenfläche (3), wobei die erste Breitseitenfläche (2) und die zweite Breitseitenfläche (3) jeweils eine Substrat- Aufnahmezone (4, 5) aufweisen, in denen Fixierelemente (14, 14', 15) vorgesehen sind, mit denen jeweils ein Substrat (6) oder Abschnitte eines Substrates (6) an der Breitseitenfläche (2, 3) befestigbar ist, wobei die Substrataufnahmezone (4, 5) zwei voneinander wegweisende erste Ränder (4') und sich quer zu den ersten Rändern (4') erstreckende zweite Ränder (11) aufweist, mit einem Handhabungsabschnitt (7) mit jeweils über den zweiten Rand (11) hinausragenden Vorsprüngen (12) anschließt, **dadurch gekennzeichnet, dass** der Substratträger ein flacher Körper ist und die von sich an die ersten Ränder (4') anschließenden Handhabungsabschnitte (7) gebildeten Vorsprünge (12) Führungsabschnitte sind, die in Führungselemente (21, 22) des CVD- oder PVD-Reaktors hineingreifen.

2. Substratträger nach Anspruch 1, **dadurch gekennzeichnet, dass** der Substratträger (1) aus Quarz besteht.

3. Substratträger nach einem der vorhergehenden Ansprüche, **dadurch gekennzeichnet, dass** die Substrat-Aufnahmezonen (4, 5) einen im Wesentlichen rechteckigen Grundriss aufweisen.

4. Substratträger nach einem der vorhergehenden Ansprüche, **dadurch gekennzeichnet, dass** der massive flache Körper eine Dicke von maximal 10 mm und eine Kantenlänge von mindestens 100 mm besitzt.

5. Substratträger nach einem der vorhergehenden Ansprüche, **dadurch gekennzeichnet, dass** der Handhabungsabschnitt (7) fensterartige Öffnungen (8, 9, 10) aufweist.

6. Substratträger nach einem der vorhergehenden Ansprüche, **dadurch gekennzeichnet, dass** zumindest ein zweiter Rand (11) der Substrat-Aufnahmezone (4, 5) eine insbesondere gerundete Randkante des Substratträgers (1) ist, um die ein flexibles Substrat (6) derart herumlegbar ist, dass das Substrat (6) mit zwei Abschnitten an jeweils einer Substrat-Aufnahmezone (4, 5) befestigbar ist.

7. Substratträger nach einem der vorhergehenden Ansprüche, **dadurch gekennzeichnet, dass** der zweite Rand (11) gegenüber einer im Wesentlichen parallel zum zweiten Rand (11) verlaufenden Randkante des Vorsprungs (12) zurückspringend verläuft.

8. CVD-Reaktor mit einem Substratträger (1) gemäß einem der vorhergehenden Ansprüche und einem Reaktorgehäuse (20), **dadurch gekennzeichnet, dass** das Reaktorgehäuse (20) Führungselemente (21, 22, 33) aufweist, entlang derer der Substratträger (1) mit seinen Vorsprüngen (12) verschiebbar ist.

9. CVD-Reaktor nach Anspruch 8, **dadurch gekennzeichnet, dass** nur die Vorsprünge (12) in von den Führungselementen (21, 22) gebildeten Nuten (21', 22', 33') eingreifen.

## Claims

1. Substrate carrier for disposing in a CVD or PVD reactor (20), in particular for separating carbon nanotubes and graphene, having a first broadside face (2) for receiving a substrate (6) to be coated and a second broadside face (3) facing away from the first broadside face (2), wherein the first broadside face (2) and the second broadside face (3) in each case include one substrate-receiving zone (4, 5) in which fixing elements (14, 14', 15) are provided, by way of which in each case one substrate (6) or portions of a substrate (6) is/are fastenable on the broadside face (2, 3), wherein the substrate-receiving zone (4, 5) has two first peripheries (4') that face away from one another, and two second peripheries (11) that extend so as to be transverse to the first peripheries (4'), with one handling portion (7) of which protrusions (12), that each protrude beyond the second periphery (11), are formed, **Characterized in that** the substrate carrier is a flat body and the protrusions (12) built by handling portions (7) adjoining to the first peripheries (4') are guiding portions, which engage with guiding elements of the CVD or PVD reactor.

2. Substrate carrier according to Claim 1, **characterized in that** the substrate carrier (1) is composed of quartz.

3. Substrate carrier according to one of the preceding claims, **characterized in that** the substrate-receiving zones (4, 5) have a substantially rectangular layout .

4. Substrate carrier according to one of the preceding claims, **characterized in that** the solid flat body has a thickness of 10 mm maximum, and an edge length of at least 100 mm.

5. Substrate carrier according to one of the preceding claims, **characterized in that** the handling portion (7) has window-type openings (8, 9, 10).

6. Substrate carrier according to one of the preceding claims, **characterized in that** at least one second periphery (11) of the substrate-receiving zone (4, 5) is, in particular, a rounded peripheral edge of the substrate carrier (1), around which a flexible substrate (6) is placeable in such a manner that the substrate (6) is fastenable by way of two portions on in each case one substrate-receiving zone (4, 5).

7. Substrate carrier according to one of the preceding claims, **characterized in that** the second periphery (11) runs in a recessed manner in relation to a peripheral edge of the protrusion (12) which runs substantially parallel with the second periphery (11).

8. CVD reactor having a substrate carrier (1) according to one of the preceding claims, and a reactor housing (20), **characterized in that** reactor housing (20) has guide elements (21, 22, 33') along which the substrate carrier (1) is displaceable by way of the protrusions (12) thereof.

9. CVD reactor according to Claim 8, **characterized in that** only the protrusions (12) engage in the grooves (21', 22', 33') formed by the guide elements (21, 22).

## Revendications

1. Support de substrat destiné à être agencé dans un réacteur CVD ou PVD (20), en particulier pour le dépôt de nanotubes de carbone et de graphène, comprenant une première face principale (2) pour recevoir un substrat (6) à revêtir et une deuxième face principale (3) orientée à l'opposé de la première face principale (2), dans lequel la première face principale (2) et la deuxième face principale (3) présentent chacune une zone de réception de substrat (4, 5) dans laquelle sont prévus des éléments de fixation (14, 14', 15) avec lesquels respectivement un substrat (6) ou des parties d'un substrat (6) peuvent être fixés à la face principale (2, 3), dans lequel la zone de réception de substrat (4, 5) a deux premiers bords (4') opposés et des deuxièmes bords (11) s'étendant transversalement par rapport aux premiers bords (4'), et comprenant une partie de manipulation (7) ayant des saillies (12) s'étendant chacune au-delà du deuxième bord (11), **caractérisé en ce que** le support de substrat est un corps plat et les saillies (12) formées par des parties de manipulation (7) adjacentes aux premiers bords (4') sont des parties de guidage qui viennent engager des éléments de guidage (21, 22) du réacteur CVD ou PVD.

2. Support de substrat selon la revendication 1, **caractérisé en ce que** le support de substrat (1) est fait de quartz.

3. Support de substrat selon l'une des revendications précédentes, **caractérisé en ce que** les zones de réception de substrat (4, 5) présentent un plan de base sensiblement rectangulaire.

4. Support de substrat selon l'une des revendications précédentes, **caractérisé en ce que** le corps plat massif présente une épaisseur maximale de 10 mm et une longueur de bord d'au moins 100 mm.

5. Support de substrat selon l'une des revendications précédentes, **caractérisé en ce que** la partie de manipulation (7) présente des ouvertures (8, 9, 10) en forme de fenêtres.

6. Support de substrat selon l'une des revendications précédentes, **caractérisé en ce qu'**au moins un deuxième bord (11) de la zone de réception de substrat (4, 5) est un bord arrondi du support de substrat (1) autour duquel peut être placé un substrat flexible (6) de manière que le substrat (6) puisse être fixé avec deux parties à une zone de réception de substrat (4, 5) respective.

7. Support de substrat selon l'une des revendications précédentes, **caractérisé en ce que** le deuxième bord (11) s'étend en retrait par rapport à un bord de la saillie (12) qui est sensiblement parallèle au deuxième bord (11).

8. Réacteur CVD comprenant un support de substrat (1) selon l'une des revendications précédentes et un boîtier de réacteur (20), **caractérisé en ce que** le boîtier de réacteur (20) comprend des éléments de guidage (21, 22, 33) le long desquels le support de substrat (1) est déplaçable avec ses saillies (12).

9. Réacteur CVD selon la revendication 8, **caractérisé en ce que** seules les saillies (12) viennent s'engager dans des rainures (21', 22', 33') formées par les éléments de guidage (21, 22).
